# EUROPÄISCHE PATENTSCHRIFT

(11) **EP 2 427 646 B1**
(45) Veröffentlichungstag und Bekanntmachung des Hinweises auf die Patenterteilung: **11.02.2015**
(21) Anmeldenummer: 10713128.6
(22) Anmeldetag: 03.04.2010
(51) Int. Cl.: F02M 25/07, F01N 5/02, F02G 5/02, H01L 35/30

(54) **ABGASFÜHRUNGSVORRICHTUNG FÜR EINE BRENNKRAFTMASCHINE MIT EINEM THERMOELEKTRISCHEN GENERATOR**
EXHAUST GAS ROUTING DEVICE FOR AN INTERNAL COMBUSTION ENGINE HAVING A THERMOELECTRICAL GENERATOR
DISPOSITIF DE GUIDAGE DES GAZ D'ÉCHAPPEMENT DESTINÉ À UN MOTEUR À COMBUSTION INTERNE DOTÉ D'UN GÉNÉRATEUR THERMOÉLECTRIQUE

(30) Priorität: 08.05.2009 DE 102009020424
(43) Veröffentlichungstag der Anmeldung: 14.03.2012
(73) Patentinhaber: Bayerische Motoren Werke Aktiengesellschaft, 80809 München (DE)
(72) Erfinder: NEUGEBAUER, Stephan, 82441 Ohlstadt (DE); EDER, Andreas, 80809 München (DE); LINDE, Matthias, 85540 Haar (DE); MAZAR, Boris, 80807 München (DE)
(86) Internationale Anmeldenummer: PCT/EP2010/002140
(87) Internationale Veröffentlichungsnummer: WO 2010/127748

(56) Entgegenhaltungen:
- DE-A1-102006 019 282
- DE-A1-102008 002 096
- JP-A- 7 012 009

## Beschreibung

Die vorliegende Erfindung betrifft eine Abgasführungsvorrichtung für eine Brennkraftmaschine mit einem thermoelektrischen Generator nach dem Oberbegriff des Anspruchs 1.

Im Zuge der Energieeinsparung ist es bei Fahrzeugen mit Brennkraftmaschinen bereits bekannt geworden, thermoelektrische Generatoren im Abgasstrang vorzusehen, die thermische Energie in elektrische Energie umwandeln. Die so gewonnene elektrische Energie kann dann beispielsweise dazu verwendet werden, elektrische Antriebe im Fahrzeug zu betreiben. Auf diese Weise kann eine Brennstoffersparnis erreicht werden, da die elektrische Energie nicht generatorisch mittels der Brennkraftmaschine bereitgestellt werden muss.

Anhand der DE 10 2005 005 077 A1 ist ein thermoelektrischer Generator für eine Brennkraftmaschine bekannt geworden. Bei diesem bekannten thermoelektrischen Generator soll eine Beschädigung der Generatorelemente dadurch vermieden werden, dass diese relativ zu einem Kühlmechanismus und zu einer Hülse bewegbar angeordnet sind.

Anhand der GB 960,324 ist ein thermoelektrisches Generatormodul bekannt geworden, welches insbesondere zur Verwendung unter hohen Temperaturen geeignet sein soll.

Aus der Druckschrift JP 07012009 A ist ein Abgaswärmetauscher mit einem thermoelektrischen Generator bekannt geworden, bei dem die Abgasleitung in Strömungsrichtung einen abnehmenden Querschnitt aufweist.

Schließlich ist anhand der DE 10 2006 019 282 A1 ein Abgasrückführsystem für eine Brennkraftmaschine bekannt geworden, welches auf die Anmelderin zurückgeht. Obwohl sich dieses bekannte Abgasrückführsystem und der dort vorgesehene thermoelektrische Generator bereits bestens bewährt haben, ist noch Raum für Verbesserungen vorhanden dahingehend, dass die Leistung des thermoelektrischen Generators verbessert werden kann.

Ausgehend hiervon liegt der vorliegenden Erfindung die Aufgabe zu Grunde, eine Vorrichtung zur Führung von Abgas für eine Brennkraftmaschine mit einem thermoelektrischen Generator bereitzustellen, der ein besseres Leistungsverhalten aufweist.

Die Erfindung weist zur Lösung dieser Aufgabe die im Anspruch 1 angegebenen Merkmale auf, vorteilhafte Ausgestaltungen hiervon sind in den weiteren Ansprüchen beschrieben.

Die Erfindung schafft eine Abgasführungsvorrichtung für eine Brennkraftmaschine mit einem thermoelektrischen Generator, der mit einem Abgasstrang und mit einer Kühlmittel führenden Leitung fluidisch verbunden ist, wobei der Generator eine Vielzahl von thermoelektrischen Schenkelpaaren aufweist, die an einer in Durchströmungsrichtung der Abgasführungsvorrichtung vorgesehenen Rohrleitung, zwischen einer vom Abgas erwärmten ersten Fläche und einer vom Kühlmittel gekühlten zweiten Fläche angeordnet sind und die Abgasführungsvorrichtung eine das Abgas entlang der ersten Fläche mit in Strömungsrichtung des Abgases zunehmender Strömungsgeschwindigkeit führende Einrichtung aufweist, wobei zwischen der Einrichtung und der Rohrleitung ein zur Durchströmung von Abgas vorgesehener und in Strömungsrichtung kleiner werdender Ringspaltraum ausgebildet ist.

Die Erfindung geht von der Erkenntnis aus, dass die Leistungsausbeute eines thermoelektrischen Generators verbessert werden kann, wenn die einzelnen thermoelektrischen Schenkelpaare des Generators jeweils eine weit gehend gleiche und hohe elektrische Leistung erbringen. Die Leistung der thermoelektrischen Schenkelpaare ist unter anderem eine Funktion der Temperaturdifferenz zwischen der heißen Seite und der kalten Seite des Schenkelpaars.

An dem Ort, an dem in eine den thermoelektrischen Generator aufweisende Abgasführungsvorrichtung das heiße Abgas eintritt, ist die Temperatur des Abgases höher als an der Austrittsseite, da das Abgas während seines Durchtritts durch die Abgasführungsvorrichtung Wärme abgibt und daher von der Einlassseite zur Auslaßseite ein Temperaturgradient besteht.

Eine gesteigerte elektrische Leistung bei Verwendung von gleichartigen thermoelektrischen Schenkelpaaren in Strömungsrichtung könnte im Idealzustand dann erreicht werden, wenn die Temperaturdifferenz zwischen der heißen und kalten Seite der thermoelektrischen Schenkelpaare entlang der Strömungsrichtung des Abgases durch die Abgasführungsvorrichtung gleich bliebe. Auch muss der Fall einer Verstimmung der entlang der Strömungsrichtung angeordneten thermoelektrischen Schenkelpaare vermieden wird.

Ein thermoelektrisches Schenkelpaar hat in Abhängigkeit der Temperaturdifferenz, der Schenkelgeometrie und des thermoelektrischen Materials einen charakteristischen elektrischen Strom zur Erreichung maximaler rekuperierter elektrischer Leistung. Eine serielle elektrische Verschaltung aller Schenkelpaare, was für die Erreichung einer nutzbaren elektrischen Spannung notwendig ist, führt somit durch den sich ändernden Temperaturgradienten in Strömungsrichtung bei konventioneller Bauweise, zu einem suboptimalen elektrischen Strom bei der Mehrzahl der thermoelektrischen Schenkelpaare und folglich zu einer verminderten Leistung.

Eine gleich bleibende Temperaturdifferenz entlang der gesamten Abgasführungsvorrichtung zwischen der Einlassseite und der Auslaßseite lässt sich im realen Betrieb einer gattungsgemäßen Abgasführungsvorrichtung nicht erzeugen. Die Erfindung löst dieses Problem auf einfache und effiziente Weise dadurch, dass die Einrichtung das Abgas entlang der ersten Fläche mit in Strömungsrichtung des Abgases zunehmender Strömungsgeschwindigkeit führt.

Damit wird erreicht, dass an der Einlassseite eine niedrigere Strömungsgeschwindigkeit des Abgases als an der Austrittsseite vorliegt. An der Einlassseite liegt aber auch eine höhere Abgastemperatur vor, als dies an der Auslaßseite der Fall ist.

Über die an der Einlassseite vorherrschende niedrigere Strömungsgeschwindigkeit wird ein vorbestimmter Wärmeübertrag von der ersten, heißen Fläche auf die dort angeordneten thermoelektrischen Schenkelpaare erreicht. Das Abgas gibt beim Durchtritt durch die Abgasführungsvorrichtung Wärme ab, so dass die Temperaturdifferenz zwischen der heißen Seite und der kalten Seite der thermoelektrischen Schenkelpaare bei einer weitgehend gleich bleibend angenommenen Temperatur des Kühlmittels abnehmen würde.

Gleichzeitig aber nimmt aufgrund der erfindungsgemäß vorgesehenen Einrichtung die Strömungsgeschwindigkeit des Abgases in Strömungsrichtung zu, wodurch der Wärmeübertrag in Strömungsrichtung des Abgases wieder verbessert werden kann und der negative Effekt eines Temperaturgradienten zwischen der Einlassseite und der Auslaßseite der Abgasführungsvorrichtung ausgeglichen werden kann.

Auf diese Weise kann die Temperaturdifferenz zwischen der heißen Seite und der kalten Seite der jeweiligen thermoelektrischen Schenkelpaare entlang der Strömungsrichtung durch die Abgasführungsvorrichtung vergleichmäßigt werden und damit auch die elektrische Leistung der thermoelektrischen Schenkelpaare, so dass das Problem einer elektrischen Verstimmung der thermoelektrischen Schenkelpaare ebenfalls beseitigt wird und die von den thermoelektrischen Schenkelpaaren rekuperierbare elektrische Leistung insgesamt erhöht werden kann.

Nach einer Weiterbildung der Erfindung ist es vorgesehen, dass die Einrichtung die Rohrleitung konzentrisch umgibt. Bei einer solchen Ausführungsform können bekannte kreisscheibenförmige thermoelektrische Schenkelpaare verwendet werden, die beispielsweise in den Ringspalt zwischen konzentrisch angeordneten Rohren eingefügt werden. Bei einer solchen Ausführungsform kann nach der Erfindung das Kühlmittel durch das innere Rohr strömen, so dass die gekühlte, zweite Fläche radial innen liegt und das äußere Rohr an seinem Außenumfang beziehungsweise der Außenumfangsmantelfläche vom heißen Abgas umströmt wird und somit die erste, vom Abgas erwärmte Fläche radial außen liegt.

Konzentrisch zu der von dem radial inneren oder radial äußeren Rohr gebildeten Rohrleitung ist die vorstehend erwähnte Einrichtung vorgesehen, die die Strömungsgeschwindigkeit des Abgases in Strömungsrichtung des Abgases von der Einlassseite der Abgasführungsvorrichtung zur Auslaßseite hin ansteigen lässt.

Die Vergrößerung der Strömungsgeschwindigkeit in Strömungsrichtung wird beispielsweise durch einen in Strömungsrichtung des Abgases durch die Abgasführungsvorrichtung hindurch kleiner werdenden Ringspaltraum zwischen der Einrichtung und der Rohrleitung, also beispielsweise der vorstehend erwähnten radial außen liegenden Rohrleitung erreicht.

Damit steigt stromaufwärts zur Einlassseite der erfindungsgemäßen Abgasführungsvorrichtung hin die Ringspaltfläche zwischen der Rohrleitung und der konzentrischen Einrichtung an und dies führt zu einer Vergrößerung des Strömungsquerschnitts. Wird der Strömungsquerschnitt im Bereich der Einlassseite mit einem Strömungsquerschnitt einer bekannten Abgasführungsvorrichtung gleich gesetzt, weist der thermoelektrische Generator der erfindungsgemäßen Abgasführungsvorrichtung am Einlass eine dieser entsprechende elektrische Leistung auf. In Strömungsrichtung nimmt die elektrische Leistung der bekannten Abgasführungsvorrichtung mit gleich bleibendem Strömungsquerschnitt aber sehr deutlich ab.

In Strömungsrichtung tritt zwischen der Einlassseite und der Auslassseite ein Temperaturgradient auf, der zu einer niedrigeren Temperatur im Bereich der Auslassseite der Abgasführungsvorrichtung führt. Ein solcher Temperaturgradient würde zu einem Leistungsabfall der thermoelektrischen Schenkelpaare in Strömungsrichtung führen, was aber bei der erfindungsgemäßen Abgasführungsvorrichtung dadurch kompensiert werden kann, dass der Strömungsquerschnitt der erfindungsgemäßen Einrichtung in Durchströmungsrichtung der Abgasführungsvorrichtung abnimmt und somit die Strömungsgeschwindigkeit ansteigt, was bei der vorherrschenden turbulenten Strömung des Abgases im Ringspalt zu einer Verbesserung der Wärmeübertragung zur heißen Seite der thermoelektrischen Schenkelpaare hin führt und somit zu einer vergrößerten elektrischen Leistung. Die vorstehende Wirkung der Abgasführungsvorrichtung kann durch die erfindungsgemäß vorgesehene kegelstumpfförmige Konfiguration der Einrichtung erreicht werden, die die Rohrleitung konzentrisch umgibt und die dafür sorgt, dass die Strömungsgeschwindigkeit des Abgases in Strömungsrichtung zunimmt.

Nach einer Weiterbildung der Erfindung ist zur Verbesserung der elektrischen Leistung vorgesehen, dass eine Vielzahl von konzentrisch zueinander verlaufend angeordneten ersten und zweiten Flächen in einem die Abgasführungsvorrichtungen aufweisenden Gehäuse angeordnet ist. Die vom Abgas erwärmten ersten Flächen sind dabei jeweils von, von der Einlassseite des Gehäuses zur Auslaßseite hin kegelstumpfförmig oder konusförmig verlaufend ausgebildeten Einrichtungen umgeben, die für eine Zunahme der Strömungsgeschwindigkeit des Abgases relativ zur ersten Fläche sorgen und damit für eine Verbesserung der elektrischen Leistung des thermoelektrischen Generators insgesamt.

Die erfindungsgemäße Abgasführungsvorrichtung kann Teil eines Abgasrückführsystems für eine Brennkraftmaschine eines Fahrzeugs sein und stromabwärts einen Abgaskühler aufweisen, der das bereits durch die erfindungsgemäße Abgasführungsvorrichtung gekühlte Abgas aufnimmt und mit einem Frischluftstrang der Brennkraftmaschine zur Abgasrückführung zur Schadstoffverringerung fluidisch verbunden ist, das heißt die erfindungsgemäße Abgasführungsvorrichtung kann in ein Abgasrückführsystem integriert werden.

Die erfindungsgemäße Abgasführungsvorrichtung zeichnet sich auch dadurch aus, dass eine Verbesserung der elektrischen Leistung des thermoelektrischen Generators dadurch erzielt wird, dass die vom Kühlmittel gekühlte zweite Fläche radial innen liegt und nicht, wie dies bei bekannten Anordnungen der Fall ist, radial außen. Die vom Abgas umströmte heiße Fläche zum Wärmeübertrag auf die thermoelektrischen Schenkelpaare liegt radial außen und die vom Kühlmittel gekühlte Fläche liegt demgemäß radial innen.

Die Erfindung wird im Folgenden anhand der Zeichnung näher erläutert. Diese zeigt in:
Fig. 1 eine Darstellung eines Funktionsaufbaus eines Abgasrückführsystems mit einer Ausführungsform der erfindungsgemäßen Abgasführungsvorrichtung;
Fig. 2 eine Schnittdarstellung durch Abgasführungsvorrichtungen nach Fig. 1;
Fig. 3 eine vergrößerte Darstellung einer Rohrleitung mit einer diese umgebenden kegelstumpfförmigen Einrichtung;
Fig. 4 eine perspektivische Darstellung einer einzelnen erfindungsgemäßen Abgasführungsvorrichtung;
Fig. 5 eine Draufsichtansicht auf eine Einlassseite eines Gehäuses mit einer Vielzahl von Abgasführungsvorrichtungen; und
Fig. 6 eine Draufsichtansicht auf die Auslaßseite des Gehäuses nach Fig. 5.

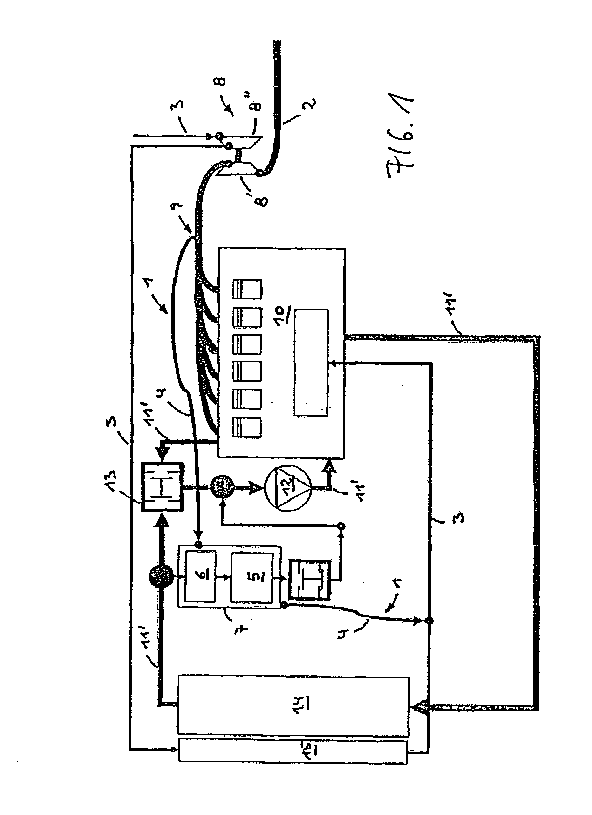

Fig. 1 der Zeichnung zeigt den Funktionsaufbau eines Abgasrückführsystems 1 für eine Brennkraftmaschine 10 mit in einem Gehäuse 7 angeordneten Abgasführungsvorrichtungen 6. Die Brennkraftmaschine 10 weist einen Abgasstrang 2 und einen Ansaugstrang sowie eine Ankoppelstelle 9 auf, an der beim Betrieb der Brennkraftmaschine 10 ein Teil des Abgases zur späteren Abgasrückführung entnommen wird.

Im Abgasstrang 2 ist eine Turbine 8' eines Turboladers 8 angeordnet, der einen Verdichter 8" im Frischluftstrang 3 antreibt. Der Verdichter 8" fördert Frischluft durch den Frischluftstrang 3 einem Ladeluftkühler 15 zu, von dem die Frischluft zur Brennkraftmaschine 10 gelangt. Das in der Brennkraftmaschine 10 entstehende Abgas wird über den Abgasstrang 2 ausgetragen.

Zur Kühlung besitzt die Brennkraftmaschine 10 einen Kühlmittelkreislauf 11'. Das von der Brennkraftmaschine 10 aufgeheizte Kühlmittel wird von einer Kühlmittelpumpe 12 einem Wärmeübertrager 14 zugeführt und anschließend durch ein Mischventil 13 wieder der Brennkraftmaschine 10 zugeleitet.

Der Abgasstrang 2 steht über eine Abgasleitung 4 mit dem Frischluftstrang 3 fluidisch in Verbindung, so dass zur Schadstoffbegrenzung Abgas in den Brennraum der Brennkraftmaschine 10 gefördert werden kann.

In einem Gehäuse 7 befinden sich eine Vielzahl von Abgasführungsvorrichtungen 6 und ein Abgaskühler 5 angeordnet, der stromabwärts der Abgasführungsvorrichtungen 6 vorgesehen ist. Die Abgasführungsvorrichtungen 6 weisen thermoelektrische Schenkelpaare 18 auf, die einen thermoelektrischen Generator ausbilden.

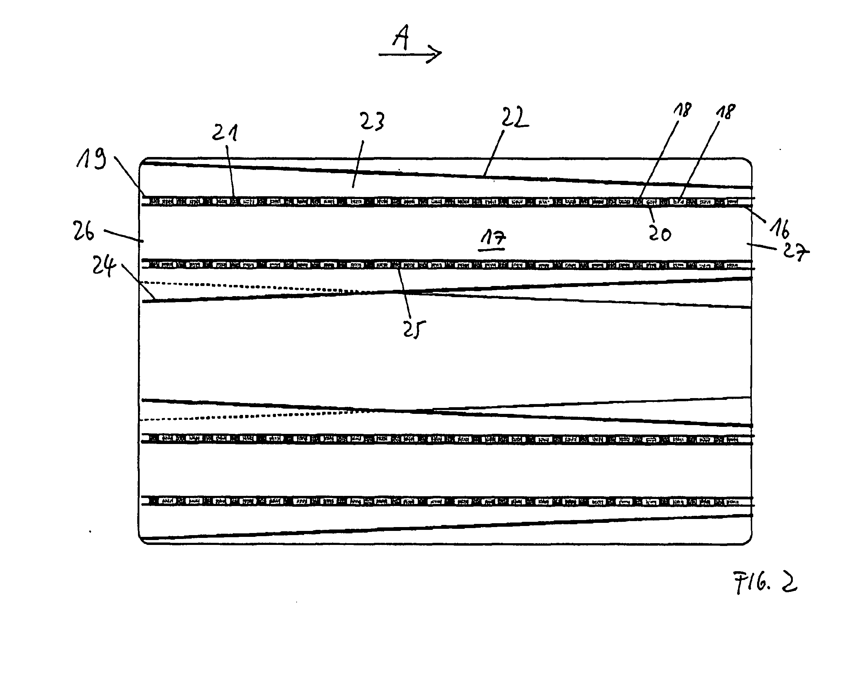

Fig. 2 der Zeichnung zeigt einen Längsschnitt durch in dem Gehäuse 7 angeordnete Abgasführungsvorrichtungen 6 nach der vorliegenden Erfindung.

Bei der dargestellten Ausführungsform weist die Abgasführungsvorrichtung 6 eine radial innen liegende Rohrleitung 16 auf, deren Innenraum 17 vom Kühlmittel aus dem Kühlmittelkreislauf der Brennkraftmaschine 10 durchströmt werden kann.

Am Außenumfang der Rohrleitung 16 befindet sich eine Vielzahl von thermoelektrischen Schenkelpaaren 18 angeordnet, deren kalte Seite demnach der innen liegenden Rohrleitung 16 zugeordnet ist. Die heiße Seite der thermoelektrischen Schenkelpaare 18 ist einer radial außen liegenden Rohrleitung 19, die konzentrisch zur Rohrleitung 16 angeordnet ist, zugeordnet. Es wird also die heiße Seite der Schenkelpaare 18 radial außen betrieben und die kalte Seite radial innen.

Bei der dargestellten Ausführungsform bildet die innen liegende Rohrleitung 16 eine zweite, vom Kühlmittel gekühlte Fläche 20 aus, während die außen liegende Rohrleitung 19 eine erste, vom Abgas erwärmte Fläche 21 ausbildet. Die thermoelektrischen Schenkelpaare 18 befinden sich zwischen der ersten Fläche 21 und der zweiten Fläche 20 angeordnet.

Konzentrisch zu den Rohrleitungen 16 und 19 befindet sich eine bei der dargestellten Ausführungsform kegelstumpfförmige Einrichtung 22 angeordnet, die einen in Strömungsrichtung (Pfeil A) des Abgases enger werdenden Ringraum 23 zwischen der inneren Umfangsmantelfläche oder Innenmantelfläche 24 der Einrichtung 22 und der außen liegenden Umfangsmantelfläche 25 der Rohrleitung 19 ausbildet.

Damit nimmt in Strömungsrichtung A des Abgases die Strömungsgeschwindigkeit des Abgases von der Einlassseite 26 der Abgasführungsvorrichtung 6 in Richtung zur Auslaßseite 27 hin zu und damit verbessert sich der Wärmeübertrag zwischen dem Abgas und der mit der Fläche 21 in Kontakt stehenden heißen Seite der thermoelektrischen Schenkelpaare 18, so dass auch bei einer in Strömungsrichtung A geringer werdenden Temperaturdifferenz zwischen dem Abgas und dem im Innenraum 17 strömenden Kühlmittel die von den thermoelektrischen Schenkelpaaren 18 abgegebene elektrische Leistung verbessert werden kann.

Im Bereich der Einlassseite 26 ist die Temperatur des Abgases hoch und die Strömungsgeschwindigkeit aufgrund des großen Strömungsquerschnitts niedrig, so dass ein ausreichender Wärmeübertrag zwischen dem Abgas und der heißen Seite der thermoelektrischen Schenkelpaare 18 realisiert werden kann. Mit in Strömungsrichtung A zunehmender Strömungsgeschwindigkeit des Abgases kann der negative Effekt eines steilen Temperaturgradienten im Abgas zwischen der Einlassseite 26 und der Auslaßseite 27 der Abgasführungsvorrichtung 6 kompensiert werden.

Im Ergebnis bedeutet dies, dass die erfindungsgemäße Abgasführungsvorrichtung 6 entlang ihrer Längsrichtung, die der Strömungsrichtung A des Abgases entspricht, für eine vergleichmäßigte elektrische Leistung des die thermoelektrischen Schenkelpaare 18 aufweisenden thermoelektrischen Generators sorgt.

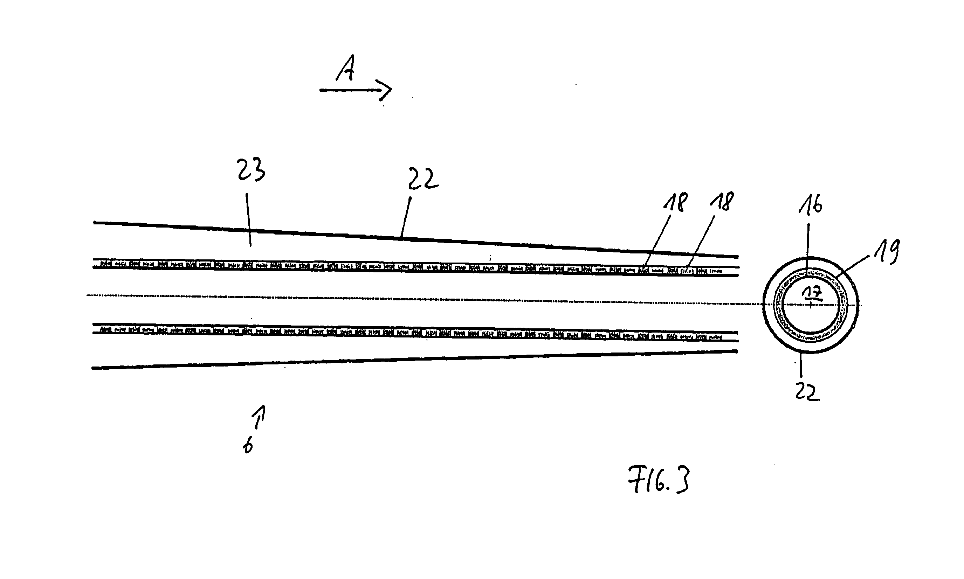

Fig. 3 der Zeichnung zeigt eine vergrößerte Darstellung einer einzelnen Abgasführungsvorrichtung 6 nach der vorliegenden Erfindung.

Wie es ohne weiteres ersichtlich ist, bildet sich bei der dargestellten Ausführungsform aufgrund der kegelstumpfförmigen Konfiguration der Einrichtung 22 zwischen der Einrichtung 22 und der Umfangsmantelfläche 25 ein Ringraum 23 mit in Strömungsrichtung A abnehmender Strömungsquerschnittsfläche aus. Dies führt zu der bereits angesprochenen Zunahme der Strömungsgeschwindigkeit in Richtung der Strömung des Abgases durch die Abgasführungsvorrichtung 6 hindurch und somit zu einem verbesserten Wärmeübertrag zwischen dem Abgas und der heißen Seite der thermoelektrischen Schenkelpaare 18. Wie es sich anhand der kreisringsförmigen Darstellung rechts neben der Fig. 3 ergibt, die eine Ansicht auf die Auslaßseite 27 der Abgasführungsvorrichtung 6 darstellt, sind bei der dargestellten Ausführungsform die Rohrleitungen 16, 19 und die Einrichtung 22 kreisringförmig und konzentrisch ausgebildet.

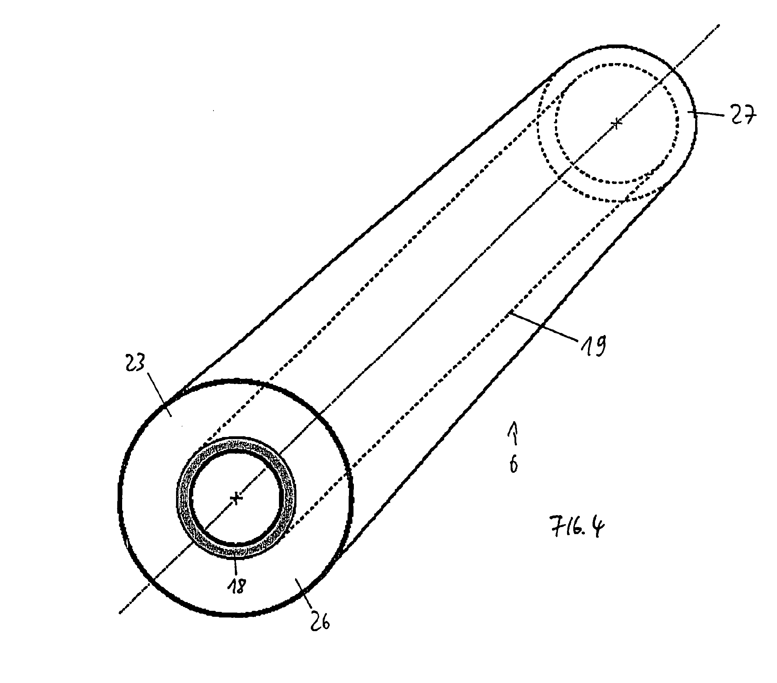

Fig. 4 zeigt eine perspektivische Darstellung der Abgasführungsvorrichtung 6. Das Abgas strömt in den Ringraum 23 an der Einlassseite 26 ein und wird dann entlang der Strömungsrichtung A auf dem Weg durch die Abgasführungsvorrichtung 6 hindurch beschleunigt und tritt an der Auslaßseite 27 aus und gibt während seiner Bewegung entlang der Rohrleitung 19 Wärme an die thermoelektrischen Schenkelpaare 18 ab.

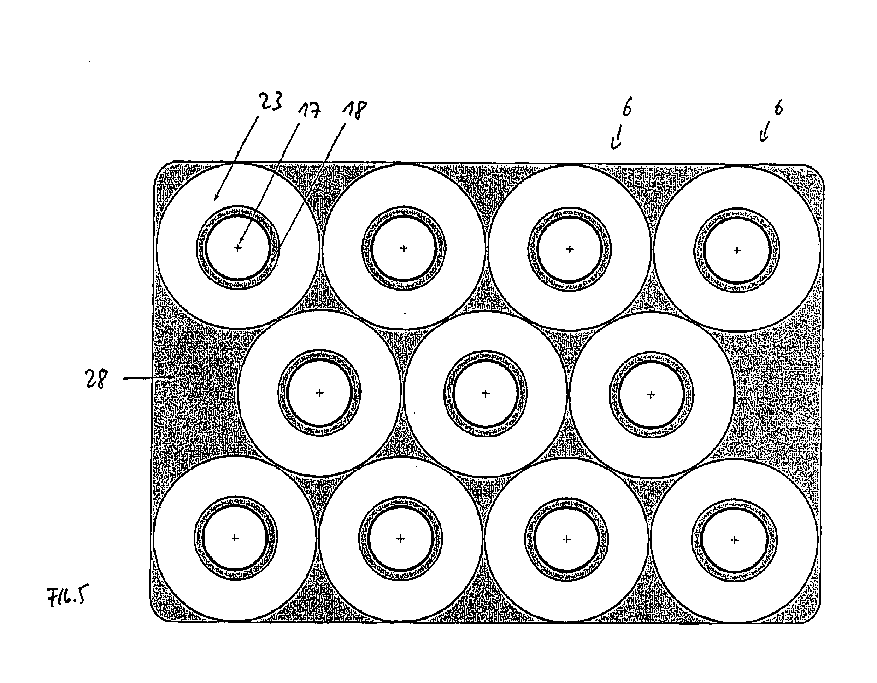

Fig. 5 der Zeichnung schließlich zeigt eine Ansicht auf eine Vorderseite des Gehäuses 7 mit nebeneinander und übereinander angeordneten Abgasführungsvorrichtungen 6. Die Außenabmessungen des Gehäuses 7 an der abgaseinlassseitigen Stirnseite 26 der Abgasführungsvorrichtungen 6 entsprechen den Außenabmessungen des vorstehend angesprochenen stapelförmigen Aufbaus der Abgasführungsvorrichtungen 6 mit nebeneinander und übereinander angeordneten Abgasführungsvorrichtungen 6.

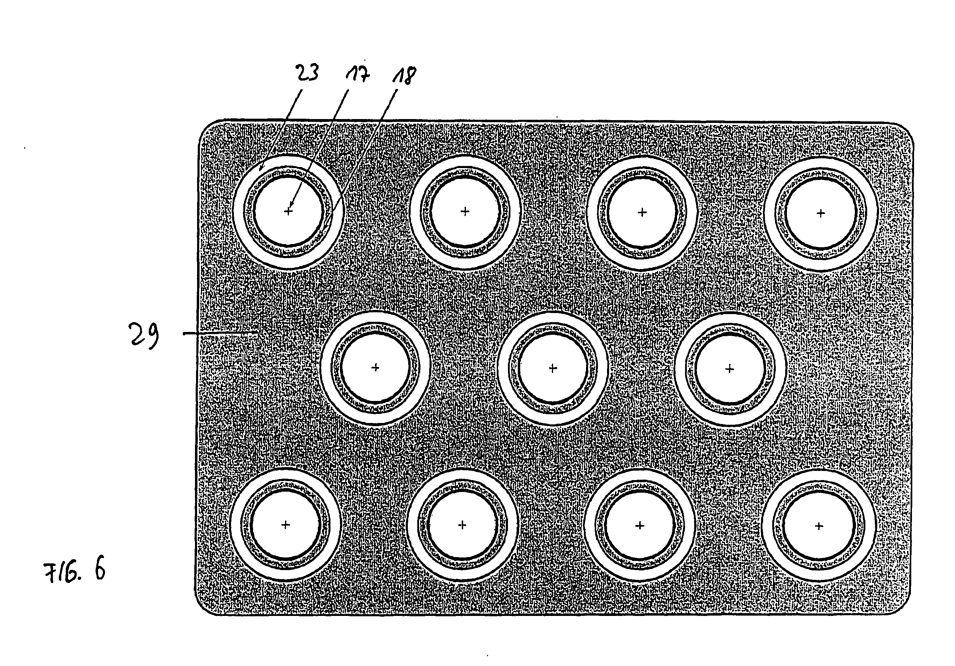

Fig. 6 zeigt eine Draufsichtansicht auf die Auslaßseite des Gehäuses 7. Wie es sich im direkten Vergleich der Figuren 5 und 6 ergibt, nimmt der für das Abgas zur Verfügung stehende Ringraum 23 bezüglich seiner Flächenausdehnung von der Einlassseite zur Auslaßseite hin kontinuierlich ab, woraus sich die bereits angesprochene zunehmende Strömungsgeschwindigkeit des Abgases auf dem Weg durch die Abgasführungsvorrichtung 6 hindurch ergibt.

Sowohl an der in Fig. 5 der Zeichnung ersichtlichen Vorderseite als auch anhand der Fig. 6, die die Auslaßseite oder Rückseite des Gehäuses 7 zeigt, ist der Raum um die Einlassseite beziehungsweise die Auslaßseite der jeweiligen Abgasführungsvorrichtungen 6 über eine Lochplatte 28 beziehungsweise 29 verschlossen. Die Lochplatte 28 verschließt den Gehäuseraum um die Einlassseiten der Abgasführungsvorrichtungen 6 herum und sorgt für eine gezielte Einleitung des Abgases in den jeweiligen Ringraum 23.

### Bezugszeichenliste

- 1: Abgasrückführsystem
- 2: Abgasstrang
- 3: Frischluftstrang
- 4: Abgasleitung
- 5: Abgaskühler
- 6: Abgasführungsvorrichtung
- 7: Gehäuse
- 8: Turbolader
- 8': Turbine
- 8": Verdichter
- 9: Ankoppelstelle
- 10: Brennkraftmaschine
- 11': Kühlmittelkreislauf
- 12: Kühlmittelpumpe
- 13: Mischventil
- 14: Wärmeübertrager
- 15: Ladeluftkühler
- 16: Rohrleitung
- 17: Innenraum
- 18: thermoelektrisches Schenkelpaar
- 19: Rohrleitung
- 20: zweite Fläche
- 21: erste Fläche
- 22: Einrichtung
- 23: Ringraum
- 24: Umfangsmantelfläche
- 25: Umfangsmantelfläche
- 26: Einlassseite
- 27: Auslaßseite
- 28: Lochplatte
- 29: Lochplatte
- A: Pfeil

## Patentansprüche

1. Abgasführungsvorrichtung für eine Brennkraftmaschine (10) mit einem thermoelektrischen Generator, der mit einem Abgasstrang (2) und mit einer Kühlmittel führenden Leitung (11') fluidisch verbunden ist und eine Vielzahl von thermoelektrischen Schenkelpaaren (18) aufweist, die an einer in Durchströmungsrichtung der Abgasführungsvorrichtung (6) vorgesehenen Rohrleitung (16, 19), zwischen einer vom Abgas erwärmten ersten Fläche (21) und einer vom Kühlmittel gekühlten zweiten Fläche (20) angeordnet sind, **dadurch gekennzeichnet, dass** die Abgasführungsvorrichtung eine das Abgas entlang der ersten Fläche (21) mit in Strömungsrichtung des Abgases zunehmender Strömungsgeschwindigkeit führende Einrichtung (22) aufweist, die die Rohrleitung (16, 19) konzentrisch umgibt und zwischen der Einrichtung (22) und der Rohrleitung (16, 19) ein zur Durchströmung von Abgas vorgesehener und in Strömungsrichtung kleiner werdender Ringspaltraum (23) ausgebildet ist.

2. Abgasführungsvorrichtung nach Anspruch 1, **dadurch gekennzeichnet, dass** die Einrichtung (22) eine kegelstumpfförmige Konfiguration aufweist und der Ringspaltraum (23) zwischen der Außenmantelfläche (25) der Rohrleitung (19) und der Innenmantelfläche (24) der Einrichtung (22) ausgebildet ist.

3. Abgasführungsvorrichtung nach Anspruch 1 oder 2, **dadurch gekennzeichnet, dass** die zweite Fläche (20) radial innerhalb der ersten Fläche (21) angeordnet ist und beide Flächen (20, 21) weitgehend konzentrisch zueinander vorgesehen sind und die radial innen liegende zweite Fläche (20) mit Kühlmittel in Kontakt steht.

4. Abgasführungsvorrichtung nach einem der vorstehenden Ansprüche, **gekennzeichnet durch** ein Gehäuse (7) mit einer Vielzahl von konzentrisch zueinander verlaufend angeordneten ersten (21) und zweiten (20) Flächen, wobei das Gehäuse (7) an einer abgaseinlassseitigen Stirnseite (26) Außenabmessungen aufweist, die weitgehend den Außenabmessungen eines Stapels nebeneinander und übereinander angeordneter Stirnflächen der Einrichtungen (22) entspricht.

5. Abgasführungsvorrichtung nach einem der vorstehenden Ansprüche, **gekennzeichnet durch** einen Abgaskühler (5), der stromabwärts der Abgasführungsvorrichtung (6) angeordnet ist und Abgas aus dieser aufnimmt und mit einem Frischluftstrang (3) der Brennkraftmaschine zur Abgasrückführung fluidisch verbunden ist.

## Claims

1. An exhaust system for an internal combustion engine (10) comprising a thermoelectric generator connected for conveying fluids to an exhaust branch (2) and a line (11') conveying coolant and has a number of thermoelectric yoke pairs (18) disposed on a pipe (16, 19) in the direction of flow of the exhaust system (6) between a first surface (21) heated by the exhaust gas and a second surface (20) cooled by the coolant, **characterised in that** the exhaust system comprises a device (22) conveying the exhaust gas along the first surface (21) at a speed increasing in the direction of flow of the exhaust gas, the device (22) concentrically surrounding the pipe (16, 19), and an annular gap (23) is formed between the device (22) and the pipe (16, 19) for a flow of exhaust gas, the gap becoming smaller in the direction of flow.

2. An exhaust system according to claim 1, **characterised in that** the device (22) has a frusto-conical shape and the annular gap (23) is formed between the outer surface (25) of the pipe (19) and the inner surface (24) of the device (22).

3. An exhaust system according to claim 1 or claim 2, **characterised in that** the second surface (20) is disposed radially inside the first surface (21) and the two surfaces (20, 21) are substantially concentric with one another and the radially inward second surface (20) is in contact with coolant.

4. An exhaust system according to any of the preceding claims, **characterised by** a casing (7) having a number of concentric first (21) and second (20) surfaces, wherein the casing (7), on an end face (26) on the exhaust inlet side, has outer dimensions substantially equal to the outer dimensions of a stack of superposed adjoining end faces of the devices (22).

5. An exhaust system according to any of the preceding claims, **characterised by** an exhaust gas cooler (5) disposed downstream of the exhaust system (6) and receiving exhaust gas therefrom and connected for conveying fluid to a fresh air branch (3) of the engine in order to recycle the exhaust.

## Revendications

1. Dispositif de guidage des gaz d'échappement pour un moteur à combustion interne (10) comportant un générateur thermoélectrique qui est en liaison fluidique avec une ligne de gaz d'échappement (2) et avec une conduite (11') transportant un agent réfrigérant, et présente plusieurs paires d'ailettes thermoélectriques (18) qui sont positionnées dans une conduite tubulaire (16, 19) située dans la direction d'écoulement du dispositif de guidage des gaz d'échappement (6) entre une première surface (21) chauffée par les gaz d'échappement est une seconde surface (20) refroidie par l'agent réfrigérant,
**caractérisé en ce que**
le dispositif de guidage des gaz d'échappement comporte un dispositif (22) guidant les gaz d'échappement le long de la première surface (21) avec une vitesse d'écoulement croissante dans la direction d'écoulement des gaz d'échappement, et qui entoure concentriquement la conduite tubulaire (16, 19) et, entre le dispositif (22) et la conduite tubulaire (16, 19) est formé un volume annulaire (23) prévu pour être parcouru par les gaz d'échappement et devenant plus petit dans la direction d'écoulement.

2. Dispositif de guidage des gaz d'échappement conforme à la revendication 1,
**caractérisé en ce que**
le dispositif (22) a une configuration en forme de tronc de cône et le volume annulaire (23) est formé entre la surface enveloppe externe (25) de la conduite tubulaire (19) et la surface enveloppe interne (24) du dispositif (22).

3. Dispositif de guidage des gaz d'échappement conforme à la revendication 1 ou 2,
**caractérisé en ce que**
la seconde surface (20) est positionnée radialement à l'intérieur de la première surface (21), les deux surfaces (20, 21) sont largement concentriques, et la seconde surface (20) située radialement vers l'intérieur est en contact avec l'agent réfrigérant.

4. Dispositif de guidage des gaz d'échappement conforme à l'une des revendications précédentes,
**caractérisé par**
un boitier (7) équipé de plusieurs premières surfaces (21) et secondes surfaces (20) s'étendant concentriquement, le boitier (7) présentant sur sa face frontale (26) située côté entrée des gaz d'échappement des dimensions externes qui correspondent largement aux dimensions externe d'un empilement de surfaces frontales des dispositifs (22) disposées côte à côte et les unes sur les autres.

5. Dispositif de guidage des gaz d'échappement conforme à l'une des revendications précédentes,
**caractérisé par**
un élément de refroidissement des gaz d'échappement (5) qui est monté en aval du dispositif de guidage des gaz d'échappement (6) et y prélève des gaz d'échappement et est en liaison fluidique avec une ligne d'air frais (3) du moteur à combustion interne pour permettre la remise en circulation des gaz d'échappement.
